# EUROPEAN PATENT APPLICATION

(11) **EP 4 521 408 A1**
(43) Date of publication of application: **12.03.2025**
(21) Application number: 23810530.8
(22) Date of filing: 11.01.2023
(51) Int. Cl.: G11C 16/04

(54) **SILICON-WAFER SYSTEM AND REPAIR METHOD THEREFOR, AND ELECTRONIC DEVICE**

(30) Priority: 26.05.2022 CN 202210584869
(71) Applicant: Huawei Technologies Co., Ltd., Shenzhen, Guangdong 518129 (CN)
(72) Inventor: ZHANG, Wenqiang, Shenzhen, Guangdong 518129 (CN); JIAO, Guangfan, Shenzhen, Guangdong 518129 (CN); JING, Weiliang, Shenzhen, Guangdong 518129 (CN); WANG, Zhengbo, Shenzhen, Guangdong 518129 (CN); LIAO, Heng, Shenzhen, Guangdong 518129 (CN)
(74) Representative: Maiwald GmbH
(86) International application number: PCT/CN2023/071808
(87) International publication number: WO 2023/226453

(57) **Abstract**

This application discloses a silicon wafer-scale system, a repair method thereof, and an electronic device. By adding an optical interconnect layer between a processor layer and a memory layer, a single processor chip at the processor layer can access data of any memory chip at the memory layer by using an optical signal through an optoelectronic conversion module, and data exchange can be performed between processor chips at the processor layer by using an optical signal through an optoelectronic conversion module. In this way, all processor chips at the processor layer are in all-to-all topological connections to memory chips at the memory layer, to increase a bandwidth between processor chips and improve a capacity of a memory that can be accessed by a single processor chip, thereby improving computing performance of the silicon wafer-scale system. In addition, because the optical interconnect layer is used as an interconnect tool between the memory layer and the processor layer, during a test, only a single damaged device unit needs to be shielded to implement a repair function, thereby improving a product yield rate.

## Description

### CROSS-REFERENCE TO RELATED APPLICATIONS

This application claims priority to Chinese Patent Application No. 202210584869.X, filed with the China National Intellectual Property Administration on May 26, 2022 and entitled "SILICON WAFER-SCALE SYSTEM, REPAIR METHOD THEREOF, AND ELECTRONIC DEVICE", which is incorporated herein by reference in its entirety.

### TECHNICAL FIELD

This application relates to the field of semiconductor technologies, and in particular, to a silicon wafer-scale system, a repair method thereof, and an electronic device.

### BACKGROUND

In application of high-performance computing and artificial intelligence, a large-scale computing task requires a large quantity of processors to perform parallel computing, for example, a central processing unit (central processing unit, CPU), a graphics processing unit (graphics processing unit, GPU), or a neural network processing unit (neural network processing unit, NPU). In a parallel computing process of a plurality of processors, a large amount of data needs to be exchanged between the processors. In addition, for the large-scale computing task, access of a large amount of data exists between a processor and a memory. Currently, a single processor and a single memory are usually separately packaged, and communication between processors or between a processor and a memory requires a long connection line. Such a long connection line causes a limited bandwidth and a large delay of communication. This becomes a bottleneck for the large-scale computing task.

To improve a bandwidth between processors and a capacity of a memory that can be accessed by a processor, a plurality of three-dimensional (3D) heterogeneous integrated silicon wafer-scale/wafer-scale systems and packaging solutions are proposed.

### SUMMARY

This application provides a silicon wafer-scale system, a repair method thereof, and an electronic device, to improve a bandwidth between processors and a capacity of a memory that can be accessed by a processor.

According to a first aspect, this application provides a silicon wafer-scale system, including: a processor layer, an optical interconnect layer, and a memory layer that are sequentially stacked. The processor layer may include a plurality of processor chips. One or more processor dies (dies) may be integrated into the processor chip. Alternatively, each processor chip may be an uncut wafer (wafer). A plurality of processor chips on a same plane form one processor layer. There may be one or more memory layers. The plurality of memory layers may be electrically interconnected (for example, electrically connected in a hybrid bonding manner), or may be optically interconnected (for example, one optical interconnect layer is added between two memory layers). Each memory layer may include a plurality of memory chips. One or more memory dies may be integrated into each memory chip. Alternatively, each memory chip may be an uncut wafer. A plurality of memory chips on a same plane form one memory layer. The optical interconnect layer may include a plurality of groups of optoelectronic conversion modules and an optical waveguide. The plurality of groups of optoelectronic conversion modules in the optical interconnect layer may be independently packaged, or may be packaged on an uncut wafer. Each group of optoelectronic conversion modules may include a photoelectric modulator and a photodetector. The photoelectric modulator and the photodetector are separately coupled to the optical waveguide. In other words, optoelectronic conversion modules are connected through the optical waveguide. Each processor chip may be electrically connected to at least one group of optoelectronic conversion modules. Each memory chip may be electrically connected to at least one group of optoelectronic conversion modules. The photoelectric modulator is configured to: convert an electrical signal from an electrically connected memory chip or an electrically connected processor chip into an optical signal, to implement conversion from electrical data to optical data; and import the optical signal into the optical waveguide for transmission. The photoelectric modulator may specifically include a plurality of types of photoelectric transistors, corresponding control circuits, and other components. The photodetector is configured to: convert an optical signal transmitted in the optical waveguide into an electrical signal, to implement conversion from optical data to electrical data; and transmit the electrical signal to an electrically connected memory chip or an electrically connected processor chip. The photodetector may specifically include a component that converts an optical signal into an electrical signal, such as a photodiode, a photomultiplier tube, or a photoconductive detector; and may further include a corresponding control circuit and the like.

According to the silicon wafer-scale system provided in this embodiment of this application, by adding the optical interconnect layer between the processor layer and the memory layer, a single processor chip at the processor layer can communicate with any memory chip at the memory layer by using an optical signal through the optical interconnect layer, and data exchange can be performed between processor chips at the processor layer by using an optical signal through the optical interconnect layer. In this way, all processor chips at the processor layer are in all-to-all topological connections to memory chips at the memory layer, to increase a bandwidth between processor chips and improve a capacity of a memory that can be accessed by a single processor chip, thereby improving computing performance of the silicon wafer-scale system.

In a possible implementation of this application, the processor layer and the optical interconnect layer may be electrically connected in a hybrid bonding manner such as face-to-face, face-to-back, back-to-back, or back-to-face. Similarly, the optical interconnect layer and the memory layer may also be electrically connected in a hybrid bonding manner such as face-to-face, face-to-back, back-to-back, or back-to-face.

Specifically, a specific manner of exchanging data between processor chips by using an optical signal is as follows: After hybrid bonding, an electrical signal output by one processor chip is transmitted to an electrically connected optoelectronic conversion module in the optical interconnect layer and converted into an optical signal, transmitted, by using the optical waveguide in the optical interconnect layer, to an optoelectronic conversion module that is electrically connected to a corresponding processor chip, and converted into the electrical signal. The electrical signal is transmitted to the corresponding processor chip through hybrid bonding, to complete data exchange between the processor chips.

Specifically, a specific manner of accessing data between a processor chip and a memory chip by using an optical signal is as follows: After hybrid bonding, an electrical signal output by one processor chip is transmitted to an electrically connected optoelectronic conversion module in the optical interconnect layer and converted into an optical signal, transmitted, by using the optical waveguide in the optical interconnect layer, to an optoelectronic conversion module that is electrically connected to a corresponding memory chip, and converted into the electrical signal. The electrical signal is transmitted to the corresponding memory chip through hybrid bonding, to complete data access between the processor chip and the memory chip.

In a possible implementation of this application, at least one of the plurality of processor chips may be further electrically connected to a vertically stacked memory chip directly through a through-silicon via in the optical interconnect layer. In this way, the processor chip and the memory chip may communicate by using an optical signal, and may further communicate by using an electrical signal. Specifically, one processor chip may have a vertical stacking relationship with one or more memory chips. One processor chip may be electrically connected to all or some vertically stacked memory chips through one or more through-silicon vias, to perform communication by using an electrical signal. Alternatively, one processor chip may have no electrical connection relationship with a vertically stacked memory chip through a through-silicon via, to perform communication only by using an optical signal. This is not limited herein.

In a possible implementation of this application, at the processor layer, some adjacent processor chips may be electrically connected through a metal interconnect line. For example, a plurality of processor chips include a first processor chip and a second processor chip that are adjacent to each other, and the first processor chip and the second processor chip are electrically connected through a metal interconnect line. In this way, the adjacent processor chips may exchange data by using an optical signal, and may also exchange data by using an electrical signal. Specifically, one processor chip may be electrically connected to one or more adjacent processor chips through a metal interconnect line, to perform communication by using an electrical signal. Alternatively, one processor chip may have no electrical connection relationship with an adjacent processor chip through a metal interconnect line, to perform communication only by using an optical signal. This is not limited herein.

In a possible implementation of this application, at the memory layer, some adjacent memory chips may be electrically connected through a metal interconnect line. For example, a plurality of memory chips include a first memory chip and a second memory chip that are adjacent to each other, and the first memory chip and the second memory chip are electrically connected through a metal interconnect line. In this way, the adjacent memory chips may exchange data by using an optical signal, and may also exchange data by using an electrical signal. Specifically, one memory chip may be electrically connected to one or more adjacent memory chips through a metal interconnect line, to perform communication by using an electrical signal. Alternatively, one memory chip may have no electrical connection relationship with an adjacent memory chip through a metal interconnect line, to perform communication only by using an optical signal. This is not limited herein.

It should be noted that "adjacent" mentioned in this application means that a distance between device units (including a memory chip and a processor chip) falls within a specified range. These device units may be in an adjacent (or referred to as neighboring) relationship; or may be a relationship of one or more device units that are spaced. An array arrangement of device units is used as an example. One device unit is adjacent to four device units in total in directions of up, down, left, and right; and is adjacent to four device units in total on diagonals. The device unit may be connected to all or a part of the eight adjacent device units through a metal interconnect line.

In a possible implementation of this application, each group of optoelectronic conversion modules are usually electrically connected to only one processor chip or one memory chip. A photoelectric modulator in one group of optoelectronic conversion modules may modulate an electrical signal received from a processor chip or a memory chip into an optical signal of a specific wavelength, to implement conversion from electrical data to optical data. A photodetector in the group of optoelectronic conversion modules may convert, into an electrical signal, an optical signal that is of a specific wavelength and that is transmitted on the optical waveguide by another processor chip or another memory chip to implement conversion from optical data to electrical data, and transmit the electrical signal to the electrically connected processor chip or memory chip. In another embodiment of this application, one group of optoelectronic conversion modules may be electrically connected to both one processor chip and one memory chip through a multiplexer. Based on a time-division selective connection function of the multiplexer, the optoelectronic conversion module may be electrically connected to the processor chip or the memory chip at a specific moment through the multiplexer.

In a possible implementation of this application, to increase an interconnect bandwidth, one processor chip may be electrically connected to a plurality of groups of optoelectronic conversion modules. Specifically, a plurality of groups of optoelectronic conversion modules that are electrically connected to one processor chip may specifically bear conversion between optical signals of a single wavelength and electrical signals. In other words, photoelectric modulators in the groups of optoelectronic conversion modules that are connected to the processor chip may respectively modulate a plurality of received electrical signals into optical signals of a same wavelength, and photodetectors in the groups of optoelectronic conversion modules that are connected to the processor chip may respectively modulate received optical signals of a same wavelength into a plurality of electrical signals. Alternatively, a plurality of groups of optoelectronic conversion modules that are electrically connected to one processor chip may bear conversion between optical signals of a plurality of wavelengths and electrical signals. In other words, photoelectric modulators in the groups of optoelectronic conversion modules that are connected to the processor chip may respectively modulate a plurality of received electrical signals into optical signals of different wavelengths, and photodetectors in the groups of optoelectronic conversion modules that are connected to the processor chip may respectively modulate received optical signals of different wavelengths into a plurality of electrical signals.

In a possible implementation of this application, to increase an interconnect bandwidth, one memory chip may be electrically connected to a plurality of groups of optoelectronic conversion modules. Specifically, a plurality of groups of optoelectronic conversion modules that are electrically connected to one memory chip may specifically bear conversion between optical signals of a single wavelength and electrical signals. In other words, photoelectric modulators in the groups of optoelectronic conversion modules that are connected to the memory chip may respectively modulate a plurality of received electrical signals into optical signals of a same wavelength, and photodetectors in the groups of optoelectronic conversion modules that are connected to the memory chip may respectively modulate received optical signals of a same wavelength into a plurality of electrical signals. Alternatively, a plurality of groups of optoelectronic conversion modules that are electrically connected to one memory chip may bear conversion between optical signals of a plurality of wavelengths and electrical signals. In other words, photoelectric modulators in the groups of optoelectronic conversion modules that are connected to the memory chip may respectively modulate a plurality of received electrical signals into optical signals of different wavelengths, and photodetectors in the groups of optoelectronic conversion modules that are connected to the memory chip may respectively modulate received optical signals of different wavelengths into a plurality of electrical signals.

In a possible implementation of this application, the silicon wafer-scale system may further include: a first drive circuit in a one-to-one correspondence with the photoelectric modulator, and a second drive circuit in a one-to-one correspondence with the photodetector. The photoelectric modulator may be electrically connected to a corresponding processor chip or memory chip through the first drive circuit. The first drive circuit is configured to drive the photoelectric modulator to work. The first drive circuit may also be referred to as a transmitter drive circuit. The photodetector may be electrically connected to a corresponding processor chip or memory chip through the second drive circuit. The second drive circuit is configured to drive the photodetector to work. The second drive circuit may also be referred to as a receiver drive circuit.

In a possible implementation of this application, both the first drive circuit and the second drive circuit may be integrated into the optical interconnect layer. At the optical interconnect layer, the first drive circuit may be electrically connected to the photoelectric modulator through a metal interconnect line, and the second drive circuit may be electrically connected to the photodetector through a metal interconnect line. The memory chip and the processor chip each may be electrically interconnected to a corresponding first drive circuit and a corresponding second drive circuit in a hybrid bonding manner.

In a possible implementation of this application, to improve an optoelectronic conversion speed and optoelectronic conversion performance, high-performance transistors formed at the processor layer may be used to implement the first drive circuit and the second drive circuit. Specifically, both the first drive circuit and the second drive circuit that are electrically connected to the processor chip may be integrated in the processor layer, and both the first drive circuit and the second drive circuit may be electrically connected to the processor chip through metal interconnect lines. The first drive circuit and the second drive circuit that are disposed at the processor layer are respectively electrically interconnected to a corresponding photodetector and a corresponding photoelectric modulator in a hybrid bonding manner.

In a possible implementation of this application, to improve an optoelectronic conversion speed and optoelectronic conversion performance, high-performance transistors formed at the processor layer may be used to implement the first drive circuit and the second drive circuit. Specifically, both the first drive circuit and the second drive circuit that are electrically connected to the memory chip may be integrated in the memory layer, and both the first drive circuit and the second drive circuit may be electrically connected to the memory chip through metal interconnect lines. The first drive circuit and the second drive circuit that are disposed at the memory layer are respectively electrically interconnected to a corresponding photodetector and a corresponding photoelectric modulator in a hybrid bonding manner.

In a possible implementation of this application, to improve an optoelectronic conversion speed and optoelectronic conversion performance, high-performance transistors formed at the memory layer and the processor layer may be used to implement the first drive circuits and the second drive circuits. Specifically, both the first drive circuit and the second drive circuit that are electrically connected to the processor chip may be integrated in the processor layer, and both the first drive circuit and the second drive circuit may be electrically connected to the processor chip through metal interconnect lines. The first drive circuit and the second drive circuit that are disposed at the processor layer are respectively electrically interconnected to a corresponding photodetector and a corresponding photoelectric modulator in a hybrid bonding manner. In addition, both the first drive circuit and the second drive circuit that are electrically connected to the memory chip may be integrated in the memory layer, and both the first drive circuit and the second drive circuit may be electrically connected to the memory chip through metal interconnect lines. The first drive circuit and the second drive circuit that are disposed at the memory layer are respectively electrically interconnected to a corresponding photodetector and a corresponding photoelectric modulator in a hybrid bonding manner.

In a possible implementation of this application, to increase an interconnect bandwidth and improve configurability of an optical path, the optical interconnect layer may include a plurality of optical waveguides. Each optical waveguide may carry optical signals of a plurality of wavelengths, or may carry optical signals of a single wavelength. This is not limited herein. In addition, the plurality of optical waveguides may include a first optical waveguide extending in a first direction and a second optical waveguide extending in a second direction, and the first direction and the second direction are crossed. For example, the first optical waveguide may extend in a horizontal direction, and the second optical waveguide may extend in a vertical direction. To change transmission directions of optical signals in the first optical waveguide and the second optical waveguide, the optical interconnect layer may further include: an optical switch disposed at a cross location of the first optical waveguide and the second optical waveguide. The optical switch can control transmission of an optical signal to be switched between the first optical waveguide and the second optical waveguide.

In a possible implementation of this application, the optical interconnect layer may further include at least one group of input/output modules. Each group of input/output modules may include an optical coupling module and an optical fiber. The optical coupling module may be specifically implemented in an edge coupling manner. The optical fiber may be coupled to the optical waveguide through the optical coupling module. Specifically, the optical fiber may be connected to one port of the optical waveguide. Different groups of input/output modules may be connected to different ends of the optical waveguide, or may be connected to a same port of the optical waveguide. This is not limited herein. For example, a group of input/output modules may be disposed to specifically transmit external data. To be specific, the group of input/output modules are used to lead out, through the optical fiber and the optical coupling module, optical signal data transmitted on the optical waveguide. For another example, another group of input/output modules may be disposed to specifically input an external signal to the optical waveguide. In other words, an external optical signal may be transmitted to the optical waveguide through a laser connected to the optical coupling module, and then transmitted to the optical interconnect layer.

In a possible implementation of this application, the silicon wafer-scale system may further include: a power supply module located on an upper side and/or a lower side of the silicon wafer-scale system. The power supply module usually includes a plurality of voltage regulator modules. If the power supply module is disposed on the upper side of the silicon wafer-scale system, that is, the power supply module is introduced from a side of the memory layer, each voltage regulator module may be connected to a through-silicon via in the memory layer through a micro bump, a solder bump, or the like, and the other end of the through-silicon via in the memory layer may be connected to a corresponding through-silicon via in the optical interconnect layer through a copper pad or a micro bump. The optical interconnect layer is connected to the memory layer in a similar manner. Therefore, each voltage regulator module may supply power to each memory chip, each optoelectronic conversion module, and each processor chip.

In a possible implementation of this application, the silicon wafer-scale system may further include: a heat dissipation module located on the upper side and/or the lower side of the silicon wafer-scale system. The heat dissipation module may specifically dissipate heat by using a cold plate. In addition, when both the heat dissipation module and the power supply module exist in the silicon wafer-scale system, the heat dissipation module and the power supply module are usually disposed on different sides of the silicon wafer-scale system. For example, the heat dissipation module is disposed on the lower side of the silicon wafer-scale system, and the power supply module is disposed on the upper side of the silicon wafer-scale system; or the heat dissipation module is disposed on the upper side of the silicon wafer-scale system, and the power supply module is disposed on the lower side of the silicon wafer-scale system. If the heat dissipation module and the power supply module are disposed on the same side (both disposed on the lower side or the upper side) of the silicon wafer-scale system, to ensure that the power supply module is connected to an external power supply, the power supply module needs to be disposed on an outermost side (for example, disposed on an uppermost side or a lowermost side), and the power supply module needs to be electrically connected to the memory layer and the processor layer through vias in the heat dissipation module.

According to a second aspect, this application further provides an electronic device. The electronic device includes a circuit board and a silicon wafer-scale system. The silicon wafer-scale system is the silicon wafer-scale system according to the first aspect or each implementation of the first aspect. The silicon wafer-scale system is electrically connected to the circuit board. A problem-resolving principle of the electronic device is similar to that of the foregoing silicon wafer-scale system. Therefore, for implementation of the electronic device, refer to the implementation of the foregoing silicon wafer-scale system. No repeated description is provided.

According to a third aspect, this application further provides a repair method of the silicon wafer-scale system according to the first aspect or each implementation of the first aspect, including: separately testing a processor layer, a memory layer, and an optical interconnect layer, to determine a damaged processor chip, a damaged memory chip, and a damaged optoelectronic conversion module; and shielding the damaged processor chip, the damaged memory chip, and the damaged optoelectronic conversion module during compiling of a program. Because the optical interconnect layer is used as an interconnect tool between the memory layer and the processor layer in the silicon wafer-scale system provided in this embodiment of this application, during a test, only a single damaged device unit (including a processor chip, a memory chip, and an optoelectronic conversion module) needs to be shielded, and a stacking relationship of the device unit does not need to be considered, to implement a repair function, thereby improving a product yield rate. Specifically, a repair process of the silicon wafer-scale system provided in this embodiment of this application is as follows: First, based on detection mark information of a known good die at the memory layer, the processor layer, and the optical interconnect layer in a test process, a compiler shields mapping of the damaged device unit (the damaged device unit includes the damaged memory chip, the damaged processor chip, and the damaged optoelectronic conversion module) in a compiling process, and compiles a corresponding program. Then, the silicon wafer-scale system loads the compiled program. Finally, input data is imported to obtain an output result.

For technical effects that can be achieved in the second aspect and the third aspect, refer to the descriptions of the technical effects that may be achieved in any possible design in the foregoing first aspect. Details are not described herein again.

### BRIEF DESCRIPTION OF DRAWINGS

FIG. 1 is a diagram of a structure of an existing wafer-to-wafer silicon wafer-scale system;
FIG. 2 is a diagram of a structure of a silicon wafer-scale system according to an embodiment of this application;
FIG. 3 is a diagram of a structure of an electronic integrated circuit wafer in a silicon wafer-scale system according to an embodiment of this application;
FIG. 4 is a diagram of a structure of a photonic integrated circuit wafer in a silicon wafer-scale system according to an embodiment of this application;
FIG. 5 is a diagram of a topological connection structure of a silicon wafer-scale system according to an embodiment of this application;
FIG. 6 is a diagram of a repair process of a silicon wafer-scale system according to an embodiment of this application;
FIG. 7 is a diagram of a circuit connection of a silicon wafer-scale system according to an embodiment of this application;
FIG. 8 is another diagram of a circuit connection of a silicon wafer-scale system according to an embodiment of this application;
FIG. 9 is another diagram of a circuit connection of a silicon wafer-scale system according to an embodiment of this application;
FIG. 10 is another diagram of a circuit connection of a silicon wafer-scale system according to an embodiment of this application; and
FIG. 11 is another diagram of a circuit connection of a silicon wafer-scale system according to an embodiment of this application.

Descriptions of reference numerals:
01: memory wafer; 011: random access memory chip; 02: processor wafer; 021: system-on-chip reticle; 03: hybrid bonding; 1: memory layer; 11: memory chip; 2: processor layer; 21: processor chip; 3: optical interconnect layer; 31: optoelectronic conversion module; 311: photoelectric modulator; 312: photodetector; 313: first drive circuit; 314: second drive circuit; 32: optical waveguide; 321: first optical waveguide; 322: second optical waveguide; 33: optical switch; 34: input/output module; 35: laser; 4: power supply module; 41: voltage regulator module; 5: heat dissipation module; 6: through-silicon via.

### DESCRIPTION OF EMBODIMENTS

Therefore, embodiments of this application provide a silicon wafer-scale system, a repair method thereof, and an electronic device, to further improve storage density of a storage array by designing and optimizing a transistor array, thereby increasing a storage capacity.

The silicon wafer-scale system may be used in various data information storage fields, for example, may be used in an electronic device such as a processor, a computer, or a server. Certainly, the silicon wafer-scale system in this embodiment of this application may also be used in another electronic device. This is not limited herein.

To make the objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

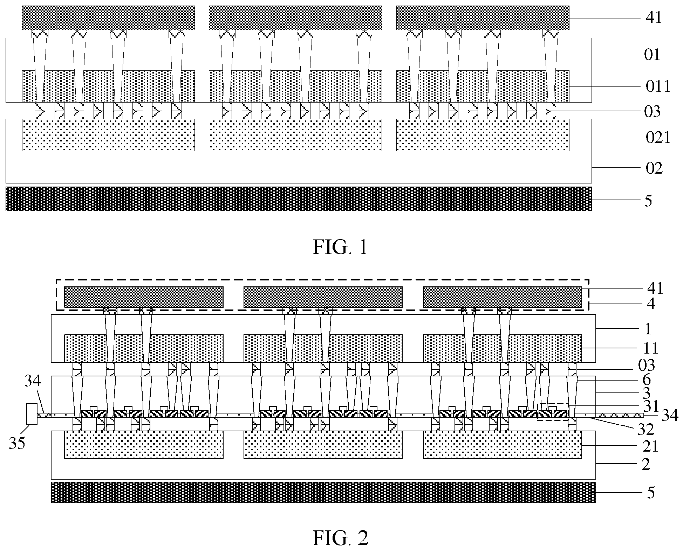

With reference to FIG. 1, a typical wafer-to-wafer (wafer-to-wafer) silicon wafer-scale system (wafer-scale engine, WSE) uses hybrid bonding (hybrid bonding, HB) 03 to interconnect a memory wafer (memory wafer) 01 and a processor wafer (processor wafer) 02. System-on-chip (system on chip, SoC) reticles (reticles) 021 included in the processor wafer are interconnected through an integrated fan-out redistribution layer (InFO-RDL) or a metal interconnect line (metallization).

In the foregoing wafer-to-wafer WSE solution, hybrid bonding is used to interconnect the memory wafer and the processor wafer. Limited by routing resources, it is difficult to directly connect SoC reticles far from each other in this solution. In addition, a single SoC reticle can access only a vertically stacked random access memory (random access memory, RAM) reticle (reticle) 011 in the processor wafer. For large-scale computing application that requires a large amount of memory, such as a graph neural network, computing performance is limited.

In addition, in this wafer-to-wafer WSE solution, because yield rates of the memory wafer and the processor wafer are superposed, yield rates of device units (including a memory chip and a processor chip) are greatly reduced, and repair (repair) needs to be performed pertinently. Because the SoC reticle can access only the vertically stacked RAM reticle, repair flexibility is poor.

On this basis, an embodiment of this application provides a silicon wafer-scale system. An optical interconnect layer is introduced between a memory layer and a processor layer, to form an optically interconnected silicon wafer-scale system. All-to-all (all-to-all) interconnection is implemented between processor chips and between a processor chip and a memory chip by using an optoelectronic conversion module and an optical waveguide at the optical interconnect layer. In addition, during a test, flexible repair may be implemented in a manner of shielding only a damaged device unit.

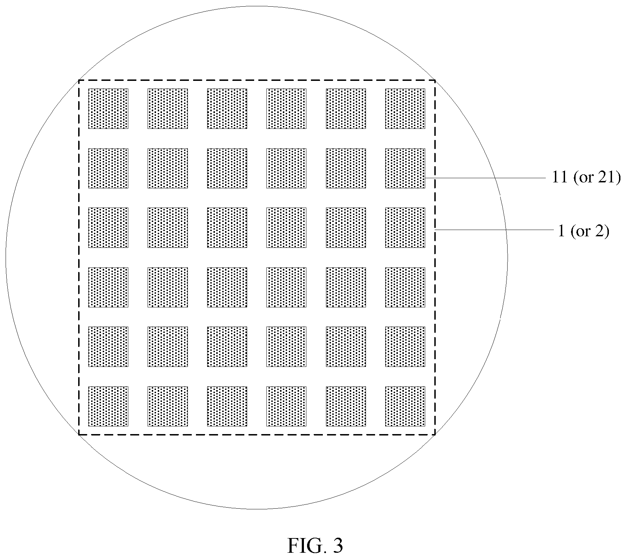

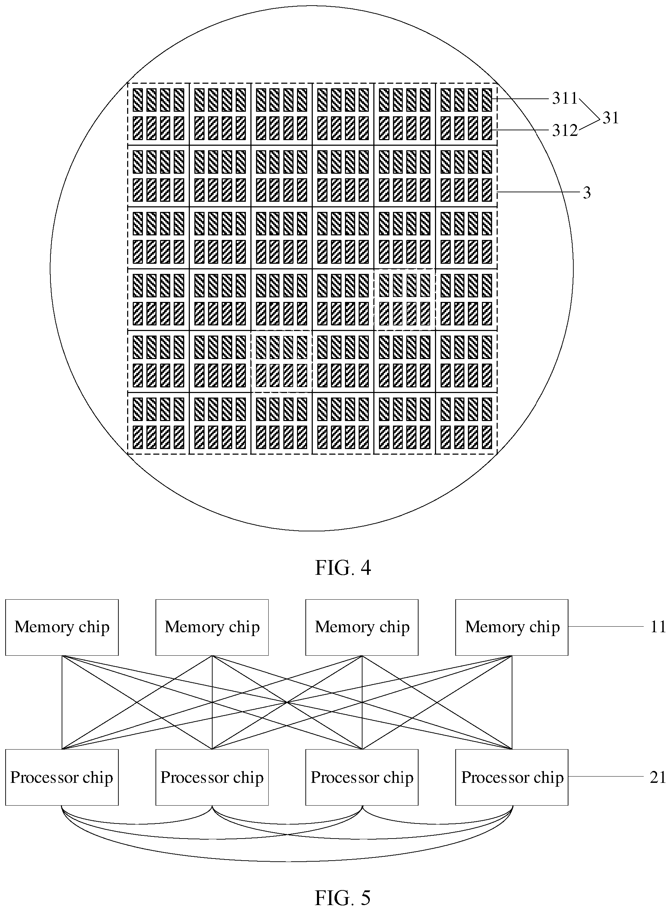

FIG. 2 is an example diagram of a structure of a silicon wafer-scale system according to an embodiment of this application. FIG. 3 is an example diagram of a structure of an electronic integrated circuit wafer in a silicon wafer-scale system according to an embodiment of this application. FIG. 4 is an example diagram of a structure of a photonic integrated circuit wafer in a silicon wafer-scale system according to an embodiment of this application.

With reference to FIG. 2 to FIG. 4, in embodiments of this application, the silicon wafer-scale system may include: a processor layer 2, an optical interconnect layer 3, and a memory layer 1 that are sequentially stacked. The processor layer 2 may include a plurality of processor chips 21. One or more processor dies (dies) may be integrated into each processor chip 21. Alternatively, each processor chip may be an uncut wafer (wafer). A plurality of processor chips on a same plane form one processor layer. There may be one or more memory layers 1. The plurality of memory layers 1 may be electrically interconnected (for example, electrically connected in a hybrid bonding manner), or may be optically interconnected (for example, one optical interconnect layer is added between two memory layers 1). Each memory layer 1 may include a plurality of memory chips 11. One or more memory dies may be integrated into each memory chip 11. Alternatively, each memory chip 11 may be an uncut wafer. A plurality of memory chips on a same plane form one memory layer. The optical interconnect layer 3 may include a plurality of groups of optoelectronic conversion modules 31 and an optical waveguide 32. The plurality of groups of optoelectronic conversion modules 31 in the optical interconnect layer 3 may be independently packaged, or may be packaged on an uncut wafer. Each group of optoelectronic conversion modules 31 may include a photoelectric modulator (modulator, MOD) 311 and a photodetector (photodetector, PD) 312. The photoelectric modulator 311 and the photodetector 312 are separately coupled to the optical waveguide 32. In other words, optoelectronic conversion modules 31 are connected through the optical waveguide 32. Each processor chip 21 may be electrically connected to at least one group of optoelectronic conversion modules 31. Each memory chip 11 may be electrically connected to at least one group of optoelectronic conversion modules 31. The photoelectric modulator 311 is configured to: convert an electrical signal from an electrically connected memory chip 11 or an electrically connected processor chip 21 into an optical signal, to implement conversion from electrical data to optical data; and import the optical signal into the optical waveguide 32 for transmission. The photoelectric modulator 311 may specifically include a plurality of types of photoelectric transistors, corresponding control circuits, and other components. The photodetector 312 is configured to: convert an optical signal transmitted in the optical waveguide 32 into an electrical signal, to implement conversion from optical data to electrical data; and transmit the electrical signal to an electrically connected memory chip 11 or an electrically connected processor chip 21. The photodetector 312 may specifically include a component that converts an optical signal into an electrical signal, such as a photodiode, a photomultiplier tube, or a photoconductive detector; and may further include a corresponding control circuit and the like.

Because communication is performed in the memory layer 1 and the processor layer 2 by using an electrical signal, the memory layer 1 and the processor layer 2 may be collectively referred to as an electronic integrated circuit (electronic integrated circuit, EIC). Because communication is performed in the optical interconnect layer 3 by using an optical signal, the optical interconnect layer 3 may be referred to as a photonic integrated circuit (photonic integrated circuit, PIC). In FIG. 3, the following example is used for description: An electronic integrated circuit wafer includes 6*6 arrayed processor chips 21 or memory chips 11. In FIG. 4, the following example is used for description: A photonic integrated circuit wafer includes 6*6 areas in dashed boxes, and each area includes four groups of optoelectronic conversion modules 31. Two groups of optoelectronic conversion modules 31 are configured to electrically connect to one processor chip 21, and the other two groups of optoelectronic conversion modules 31 are configured to electrically connect to one memory chip 11.

FIG. 5 is a diagram of a topological connection structure of a silicon wafer-scale system according to an embodiment of this application. With reference to FIG. 5, according to the silicon wafer-scale system provided in this embodiment of this application, by adding an optical interconnect layer 3 between a processor layer 2 and a memory layer 1, a single processor chip 21 at the processor layer 2 can communicate with any memory chip 11 at the memory layer 1 by using an optical signal through the optical interconnect layer 3, and data exchange can be performed between processor chips 21 at the processor layer 2 by using an optical signal through the optical interconnect layer 3. In this way, all processor chips 21 at the processor layer 2 are in all-to-all topological connections to memory chips 11 at the memory layer 1, to increase a bandwidth between processor chips 21 and improve a capacity of a memory that can be accessed by a single processor chip 21, thereby improving computing performance of the silicon wafer-scale system.

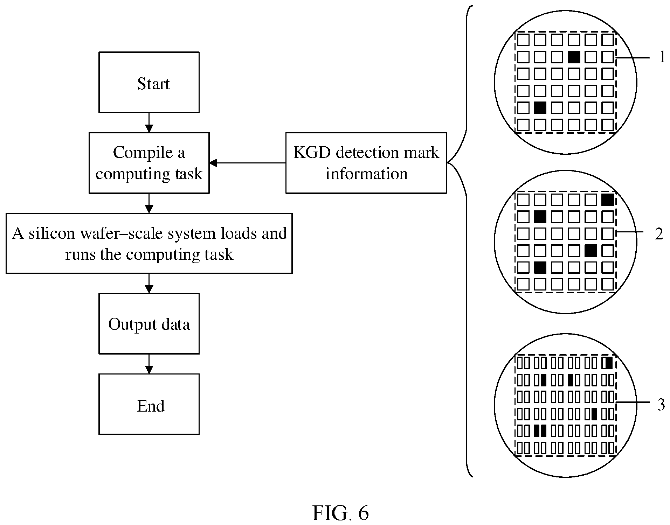

FIG. 6 is a diagram of a repair process of a silicon wafer-scale system according to an embodiment of this application. This embodiment of this application further provides the repair method of the silicon wafer-scale system, including: separately testing a processor layer, a memory layer, and an optical interconnect layer, to determine a damaged processor chip, a damaged memory chip, and a damaged optoelectronic conversion module; and shielding the damaged processor chip, the damaged memory chip, and the damaged optoelectronic conversion module during compiling of a program. Because the optical interconnect layer 3 is used as an interconnect tool between the memory layer 1 and the processor layer 2 in the silicon wafer-scale system provided in this embodiment of this application, during a test, only a single damaged device unit (including a processor chip 21, a memory chip 11, and an optoelectronic conversion module 31) needs to be shielded, and a stacking relationship of the device unit does not need to be considered, to implement a repair function, thereby improving a product yield rate. With reference to FIG. 6, a repair process of the silicon wafer-scale system provided in this embodiment of this application is as follows: First, based on detection mark information of a known good die (known good die, KGD) at the memory layer 1, the processor layer 2, and the optical interconnect layer 3 in a test process, a compiler shields mapping of the damaged device unit (the damaged device unit includes the damaged memory chip 11, the damaged processor chip 21, and the damaged optoelectronic conversion module 31, and a black filled part in FIG. 6 represents a damaged device unit) in a compiling process, and compiles a corresponding program. Then, the silicon wafer-scale system loads the compiled program. Finally, input data is imported to obtain an output result.

With reference to FIG. 2, in an embodiment of this application, the processor layer 2 and the optical interconnect layer 3 may be electrically connected in a hybrid bonding 03 manner such as face-to-face (face-to-face), face-to-back (face-to-back), back-to-back (back-to-back), or back-to-face (back-to-face). Similarly, the optical interconnect layer 3 and the memory layer 1 may also be electrically connected in a hybrid bonding 03 manner such as face-to-face, face-to-back, back-to-back, or back-to-face.

Specifically, a specific manner of exchanging data between processor chips 21 by using an optical signal is as follows: After hybrid bonding 03, an electrical signal output by one processor chip 21 is transmitted to an electrically connected optoelectronic conversion module 31 in the optical interconnect layer 3 and converted into an optical signal, transmitted, by using the optical waveguide 32 in the optical interconnect layer 3, to an optoelectronic conversion module 31 that is electrically connected to a corresponding processor chip 21, and converted into the electrical signal. The electrical signal is transmitted to the corresponding processor chip 21 through hybrid bonding 03, to complete data exchange between the processor chips 21.

Specifically, a specific manner of accessing data between a processor chip 21 and a memory chip 11 by using an optical signal is as follows: After hybrid bonding 03, an electrical signal output by one processor chip 21 is transmitted to an electrically connected optoelectronic conversion module 31 in the optical interconnect layer 3 and converted into an optical signal, transmitted, by using the optical waveguide 32 in the optical interconnect layer 3, to an optoelectronic conversion module 31 that is electrically connected to a corresponding memory chip 11, and converted into the electrical signal. The electrical signal is transmitted to the corresponding memory chip 11 through hybrid bonding 03, to complete data access between the processor chip 21 and the memory chip 11.

With reference to FIG. 2, in an embodiment of this application, at least one of the plurality of processor chips 21 may be further electrically connected to a vertically stacked memory chip 11 directly through a through-silicon via (through-silicon via, TSV) 6 in the optical interconnect layer 3. In this way, the processor chip 21 and the memory chip 11 may communicate by using an optical signal, and may further communicate with each other by using an electrical signal. Specifically, one processor chip 21 may have a vertical stacking relationship with one or more memory chips 11. One processor chip 21 may be electrically connected to all or some vertically stacked memory chips 11 through one or more through-silicon vias 6, to perform communication by using an electrical signal. Alternatively, one processor chip 21 may have no electrical connection relationship with a vertically stacked memory chip 11 through a through-silicon via, to perform communication only by using an optical signal. This is not limited herein.

In an embodiment of this application, at the processor layer 2, some adjacent processor chips 21 may be electrically connected through a metal interconnect line. For example, a plurality of processor chips 21 include a first processor chip and a second processor chip that are adjacent to each other, and the first processor chip and the second processor chip are electrically connected through a metal interconnect line. In this way, the adjacent processor chips 21 may exchange data by using an optical signal, and may also exchange data by using an electrical signal. Specifically, one processor chip 21 may be electrically connected to one or more adjacent processor chips 21 through a metal interconnect line, to perform communication by using an electrical signal. Alternatively, one processor chip 21 may have no electrical connection relationship with an adjacent processor chip 21 through a metal interconnect line, to perform communication only by using an optical signal. This is not limited herein.

Similarly, in an embodiment of this application, at the memory layer 1, some adjacent memory chips 11 may be electrically connected through a metal interconnect line. For example, a plurality of memory chips 11 include a first memory chip and a second memory chip that are adjacent to each other, and the first memory chip and the second memory chip are electrically connected through a metal interconnect line. In this way, the adjacent memory chips 11 may exchange data by using an optical signal, and may also exchange data by using an electrical signal. Specifically, one memory chip 11 may be electrically connected to one or more adjacent memory chips 11 through a metal interconnect line, to perform communication by using an electrical signal. Alternatively, one memory chip 11 may have no electrical connection relationship with an adjacent memory chip 11 through a metal interconnect line, to perform communication only by using an optical signal. This is not limited herein.

It should be noted that "adjacent" mentioned in this application means that a distance between device units (including a memory chip 11 and a processor chip 21) falls within a specified range. These device units may be in an adjacent (or referred to as neighboring) relationship; or may be a relationship of one or more device units that are spaced. An array arrangement of device units is used as an example. One device unit is adjacent to four device units in total in directions of up, down, left, and right; and is adjacent to four device units in total on diagonals. The device unit may be connected to all or a part of the eight adjacent device units through a metal interconnect line.

With reference to FIG. 2, in an embodiment of this application, each group of optoelectronic conversion modules 31 are usually electrically connected to only one processor chip 21 or one memory chip 11. A photoelectric modulator 311 in one group of optoelectronic conversion modules 31 may modulate an electrical signal received from a processor chip 21 or a memory chip 11 into an optical signal of a specific wavelength, to implement conversion from electrical data to optical data. A photodetector 312 in the group of optoelectronic conversion modules 31 may convert, into an electrical signal, an optical signal that is of a specific wavelength and that is transmitted on the optical waveguide 32 by another processor chip 21 or another memory chip 11 to implement conversion from optical data to electrical data, and transmit the electrical signal to an electrically connected processor chip 21 or memory chip 11. In another embodiment of this application, one group of optoelectronic conversion modules 31 may be electrically connected to both one processor chip 21 and one memory chip 11 through a multiplexer. Based on a time-division selective connection function of the multiplexer, the optoelectronic conversion module 31 may be electrically connected to the processor chip 21 or the memory chip 11 at a specific moment through the multiplexer.

With reference to FIG. 2, in an embodiment of this application, to increase an interconnect bandwidth, one processor chip 21 may be electrically connected to a plurality of groups of optoelectronic conversion modules 31. In FIG. 2, an example in which one processor chip 21 is electrically connected to two groups of optoelectronic conversion modules 31 is used for description. Specifically, the plurality of groups of optoelectronic conversion modules 31 that are electrically connected to the processor chip 21 may specifically bear conversion between optical signals of a single wavelength and electrical signals. In other words, photoelectric modulators 311 in the groups of optoelectronic conversion modules 31 that are connected to the processor chip 21 may respectively modulate a plurality of received electrical signals into optical signals of a same wavelength, and photodetectors 312 in the groups of optoelectronic conversion modules 31 that are connected to the processor chip 21 may respectively modulate received optical signals of a same wavelength into a plurality of electrical signals. Alternatively, the plurality of groups of optoelectronic conversion modules 31 that are electrically connected to the processor chip 21 may bear conversion between optical signals of a plurality of wavelengths and electrical signals. In other words, photoelectric modulators 311 in the groups of optoelectronic conversion modules 31 that are connected to the processor chip 21 may respectively modulate a plurality of received electrical signals into optical signals of different wavelengths, and photodetectors 312 in the groups of optoelectronic conversion modules 31 that are connected to the processor chip 21 may respectively modulate received optical signals of different wavelengths into a plurality of electrical signals.

Similarly, with reference to FIG. 2, in an embodiment of this application, to increase an interconnect bandwidth, one memory chip 11 may be electrically connected to a plurality of groups of optoelectronic conversion modules 31. In FIG. 2, an example in which one memory chip 11 is electrically connected to two groups of optoelectronic conversion modules 31 is used for description. Specifically, the plurality of groups of optoelectronic conversion modules 31 that are electrically connected to the memory chip 11 may specifically bear conversion between optical signals of a single wavelength and electrical signals. In other words, photoelectric modulators 311 in the groups of optoelectronic conversion modules 31 that are connected to the memory chip 11 may respectively modulate a plurality of received electrical signals into optical signals of a same wavelength, and photodetectors 312 in the groups of optoelectronic conversion modules 31 that are connected to the memory chip 11 may respectively modulate received optical signals of a same wavelength into a plurality of electrical signals. Alternatively, the plurality of groups of optoelectronic conversion modules 31 that are electrically connected to the memory chip 11 may bear conversion between optical signals of a plurality of wavelengths and electrical signals. In other words, photoelectric modulators 311 in the groups of optoelectronic conversion modules 31 that are connected to the memory chip 11 may respectively modulate a plurality of received electrical signals into optical signals of different wavelengths, and photodetectors 312 in the groups of optoelectronic conversion modules 31 that are connected to the memory chip 11 may respectively modulate received optical signals of different wavelengths into a plurality of electrical signals.

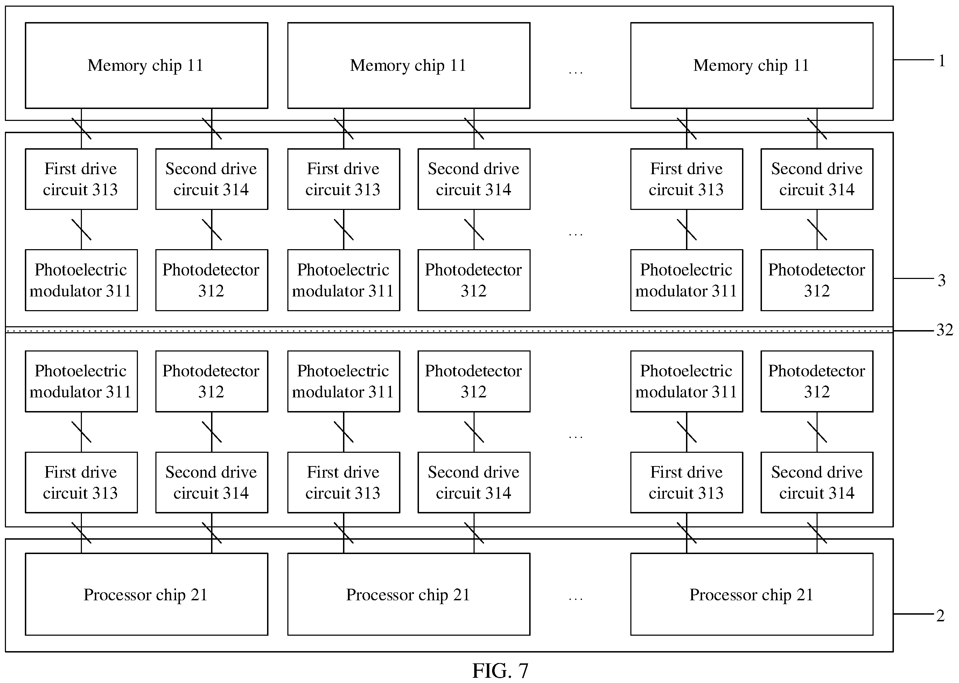

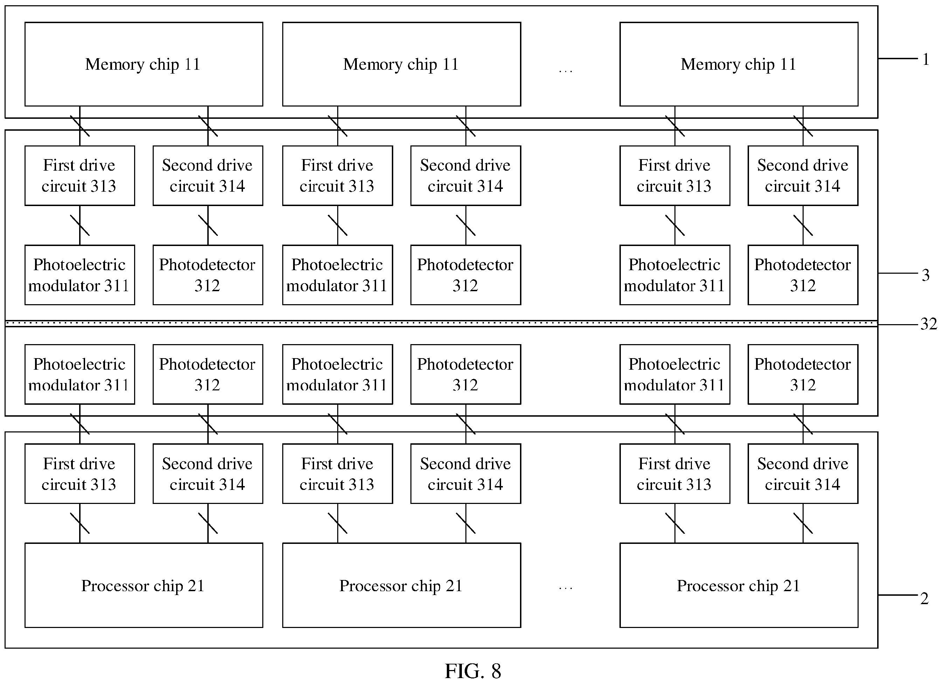

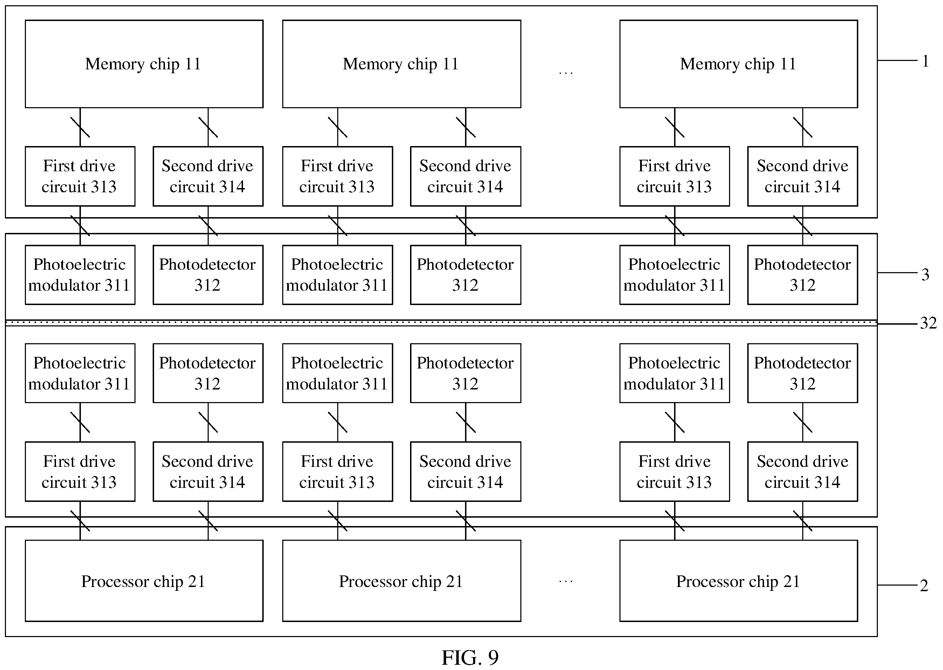

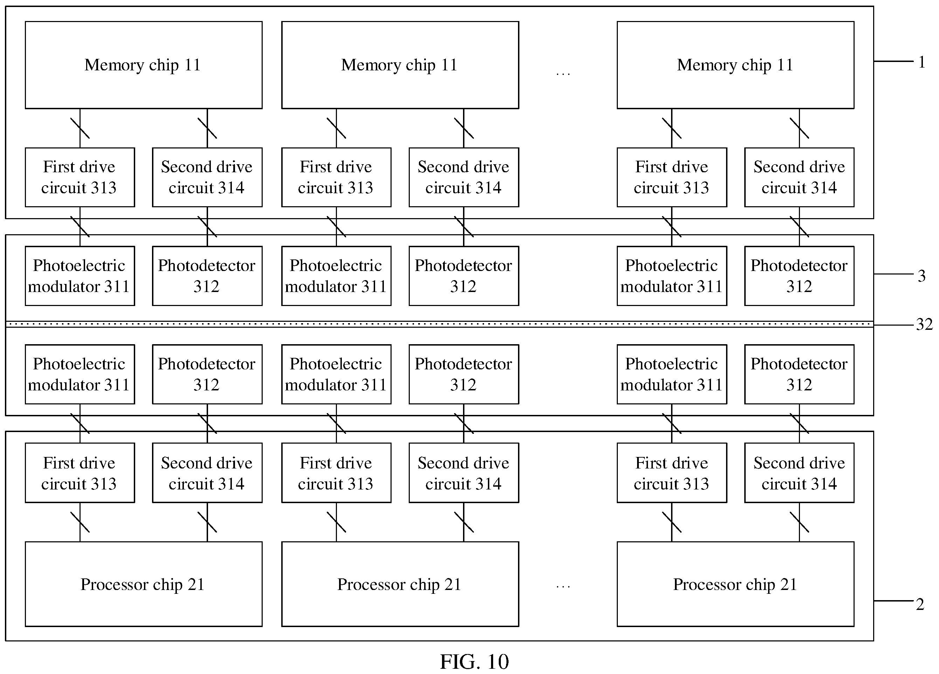

FIG. 7 is a diagram of a circuit connection of a silicon wafer-scale system according to an embodiment of this application. FIG. 8 is another diagram of a circuit connection of a silicon wafer-scale system according to an embodiment of this application. FIG. 9 is another diagram of a circuit connection of a silicon wafer-scale system according to an embodiment of this application. FIG. 10 is another diagram of a circuit connection of a silicon wafer-scale system according to an embodiment of this application.

With reference to FIG. 7 to FIG. 10, in an embodiment of this application, the silicon wafer-scale system may further include: a first drive circuit 313 in a one-to-one correspondence with the photoelectric modulator 311, and a second drive circuit 314 in a one-to-one correspondence with the photodetector 312. The photoelectric modulator 311 may be electrically connected to a corresponding processor chip 21 or memory chip 11 through the first drive circuit 313. The first drive circuit 313 is configured to drive the photoelectric modulator 311 to work. The first drive circuit 313 may also be referred to as a transmitter (transmitter, Tx) drive circuit (driver). The photodetector 312 may be electrically connected to a corresponding processor chip 21 or memory chip 11 through the second drive circuit 314. The second drive circuit 314 is configured to drive the photodetector 312 to work. The second drive circuit 314 may also be referred to as a receiver (receiver, Rx) drive circuit.

Specifically, with reference to FIG. 7, in an embodiment of this application, both the first drive circuit 313 and the second drive circuit 314 may be integrated into the optical interconnect layer 3. At the optical interconnect layer 3, the first drive circuit 313 may be electrically connected to the photoelectric modulator 311 through a metal interconnect line, and the second drive circuit 314 may be electrically connected to the photodetector 312 through a metal interconnect line. The memory chip 11 and the processor chip 21 may be electrically interconnected to a corresponding first drive circuit 313 and a corresponding second drive circuit 314 in a hybrid bonding manner.

With reference to FIG. 8, in another embodiment of this application, to improve an optoelectronic conversion speed and optoelectronic conversion performance, high-performance transistors formed at the processor layer 2 may be used to implement the first drive circuit 313 and the second drive circuit 314. Specifically, both the first drive circuit 313 and the second drive circuit 314 that are electrically connected to the processor chip 21 may be integrated in the processor layer 2, and both the first drive circuit 313 and the second drive circuit 314 may be electrically connected to the processor chip 21 through metal interconnect lines. The first drive circuit 313 and the second drive circuit 314 that are disposed at the processor layer 2 are respectively electrically interconnected to a corresponding photodetector 312 and a corresponding photoelectric modulator 311 in a hybrid bonding manner.

With reference to FIG. 9, in another embodiment of this application, to improve an optoelectronic conversion speed and optoelectronic conversion performance, high-performance transistors formed at the processor layer 2 may be used to implement the first drive circuit 313 and the second drive circuit 314. Specifically, both the first drive circuit 313 and the second drive circuit 314 that are electrically connected to the memory chip 11 may be integrated in the memory layer 1, and both the first drive circuit 313 and the second drive circuit 314 may be electrically connected to the memory chip 11 through metal interconnect lines. The first drive circuit 313 and the second drive circuit 314 that are disposed at the memory layer 1 are respectively electrically interconnected to a corresponding photodetector 312 and a corresponding photoelectric modulator 311 in a hybrid bonding manner.

With reference to FIG. 10, in another embodiment of this application, to improve an optoelectronic conversion speed and optoelectronic conversion performance, high-performance transistors formed at the memory layer 1 and the processor layer 2 may be used to implement the first drive circuits 313 and the second drive circuits 314. Specifically, both the first drive circuit 313 and the second drive circuit 314 that are electrically connected to the processor chip 21 may be integrated in the processor layer 2, and both the first drive circuit 313 and the second drive circuit 314 may be electrically connected to the processor chip 21 through metal interconnect lines. The first drive circuit 313 and the second drive circuit 314 that are disposed at the processor layer 2 are respectively electrically interconnected to a corresponding photodetector 312 and a corresponding photoelectric modulator 311 in a hybrid bonding manner. In addition, both the first drive circuit 313 and the second drive circuit 314 that are electrically connected to the memory chip 11 may be integrated in the memory layer 1, and both the first drive circuit 313 and the second drive circuit 314 may be electrically connected to the memory chip 11 through metal interconnect lines. The first drive circuit 313 and the second drive circuit 314 that are disposed at the memory layer 1 are respectively electrically interconnected to a corresponding photodetector 312 and a corresponding photoelectric modulator 311 in a hybrid bonding manner.

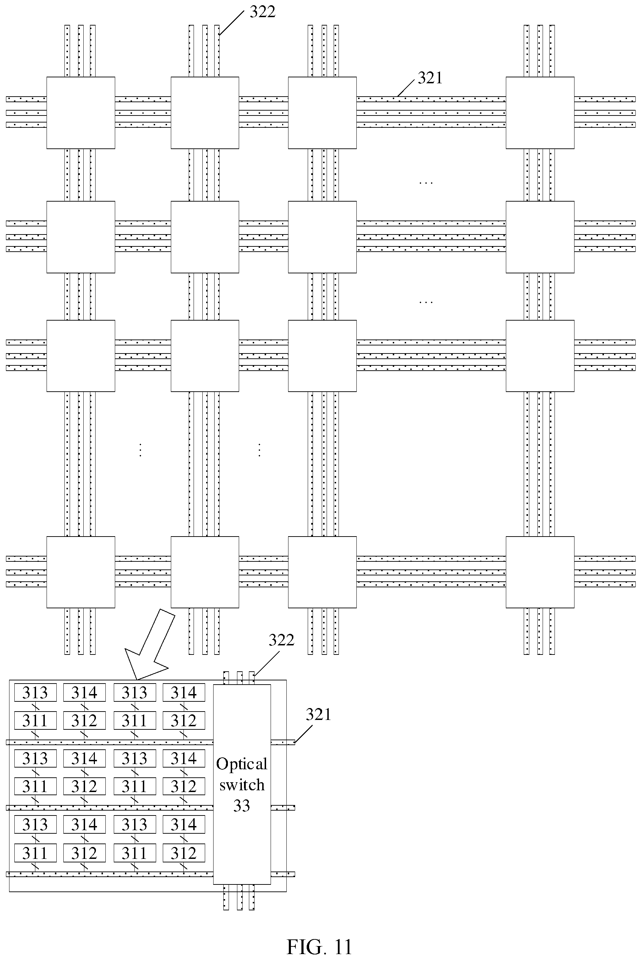

With reference to FIG. 11, in another embodiment of this application, to increase an interconnect bandwidth and improve configurability of an optical path, the optical interconnect layer 3 may include a plurality of optical waveguides 32. Each optical waveguide 32 may carry optical signals of a plurality of wavelengths, or may carry optical signals of a single wavelength. This is not limited herein. In addition, the plurality of optical waveguides 32 may include a first optical waveguide 321 extending in a first direction and a second optical waveguide 322 extending in a second direction, and the first direction and the second direction are crossed. For example, the first optical waveguide 321 may extend in a horizontal direction, and the second optical waveguide 322 may extend in a vertical direction. To change transmission directions of optical signals in the first optical waveguide 321 and the second optical waveguide 322, the optical interconnect layer 3 may further include: an optical switch 33 (photonic switch) disposed at a cross location of the first optical waveguide 321 and the second optical waveguide 322. The optical switch 33 can control transmission of an optical signal to be switched between the first optical waveguide 321 and the second optical waveguide 322.

With reference to FIG. 2, in an embodiment of this application, the optical interconnect layer 3 may further include at least one group of input/output modules 34. Each group of input/output modules 34 may include an optical coupling module and an optical fiber. The optical coupling module may be specifically implemented in an edge coupling manner. The optical fiber may be coupled to the optical waveguide 32 through the optical coupling module. Specifically, the optical fiber may be connected to one port of the optical waveguide 32. Different groups of input/output modules 34 may be connected to different ends of the optical waveguide 32, or may be connected to a same port of the optical waveguide 32. This is not limited herein. For example, a group of input/output modules 34 (an input/output module 34 on a right side of FIG. 2) may be disposed to specifically transmit external data. To be specific, the group of input/output modules 34 are used to lead out, through the optical fiber and the optical coupling module, optical signal data transmitted on the optical waveguide 32. For another example, another group of input/output modules 34 (an input/output module 34 on a left side of FIG. 2) may be disposed to specifically input an external signal to the optical waveguide 32. In other words, an external optical signal may be transmitted to the optical waveguide 32 through a laser 35 connected to the optical coupling module, and then transmitted to the optical interconnect layer 3.

With reference to FIG. 2, in an embodiment of this application, the silicon wafer-scale system may further include: a power supply module 4 located on an upper side and/or a lower side of the silicon wafer-scale system. FIG. 2 is described by using an example in which the power supply module 4 is disposed on the upper side. The power supply module 4 usually includes a plurality of voltage regulator modules (voltage regulator modules, VRMs) 41. If the power supply module 4 is disposed on the upper side of the silicon wafer-scale system, that is, the power supply module 4 is introduced from a side of the memory layer 1, each voltage regulator module 41 may be connected to a TSV in the memory layer 1 through a micro bump (micro bump), a solder bump (solder bump), or the like, and the other end of the TSV in the memory layer 1 may be connected to a corresponding TSV in the optical interconnect layer 3 through a copper pad (Cu pad) or a micro bump. The optical interconnect layer 3 is connected to the memory layer 1 in a similar manner. Therefore, each voltage regulator module 41 may supply power to each memory chip 11, each optoelectronic conversion module 31, and each processor chip 21.

With reference to FIG. 2, in an embodiment of this application, the silicon wafer-scale system may further include: a heat dissipation module 5 located on the upper side and/or the lower side of the silicon wafer-scale system. The heat dissipation module 5 may specifically dissipate heat by using a cold plate (cold plate). FIG. 2 is described by using an example in which the heat dissipation module 5 is disposed on the lower side. In addition, when both the heat dissipation module 5 and the power supply module 4 exist in the silicon wafer-scale system, the heat dissipation module 5 and the power supply module 4 are usually disposed on different sides of the silicon wafer-scale system. For example, as shown in FIG. 2, the heat dissipation module 5 is disposed on the lower side of the silicon wafer-scale system, and the power supply module 4 is disposed on the upper side of the silicon wafer-scale system; or the heat dissipation module 5 is disposed on the upper side of the silicon wafer-scale system, and the power supply module 4 is disposed on the lower side of the silicon wafer-scale system. If the heat dissipation module 5 and the power supply module 4 are disposed on the same side (both disposed on the lower side or the upper side) of the silicon wafer-scale system, to ensure that the power supply module 4 is connected to an external power supply, the power supply module 4 needs to be disposed on an outermost side (for example, disposed on an uppermost side or a lowermost side), and the power supply module 4 needs to be electrically connected to the memory layer 1 and the processor layer 2 through vias in the heat dissipation module 5.

Based on a same technical concept, this application further provides an electronic device. The electronic device includes a circuit board and a silicon wafer-scale system, the silicon wafer-scale system includes any silicon wafer-scale system provided in embodiments of this application, and the silicon wafer-scale system is electrically connected to the circuit board. A problem-resolving principle of the electronic device is similar to that of the foregoing silicon wafer-scale system. Therefore, for implementation of the electronic device, refer to the implementation of the foregoing silicon wafer-scale system. No repeated description is provided.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. A silicon wafer-scale system, comprising: a processor layer, an optical interconnect layer, and a memory layer that are sequentially stacked, wherein
the processor layer comprises a plurality of processor chips, and the memory layer comprises a plurality of memory chips; and
the optical interconnect layer comprises a plurality of groups of optoelectronic conversion modules and an optical waveguide, each group of optoelectronic conversion modules in the plurality of groups of optoelectronic conversion modules comprise a photoelectric modulator and a photodetector, the photoelectric modulator and the photodetector are separately coupled to the optical waveguide, each processor chip is electrically connected to at least one group of optoelectronic conversion modules, and each memory chip is electrically connected to at least one group of optoelectronic conversion modules.

2. The silicon wafer-scale system according to claim 1, wherein at least one of the plurality of processor chips is electrically connected to a vertically stacked memory chip through a through-silicon via in the optical interconnect layer.

3. The silicon wafer-scale system according to claim 1 or 2, wherein each group of optoelectronic conversion modules in the plurality of groups of optoelectronic conversion modules are electrically connected to only one of the processor chips or one of the memory chips.

4. The silicon wafer-scale system according to claim 3, wherein each of the plurality of processor chips is electrically connected to some of the plurality of groups of optical-to-electrical conversion modules; and
the plurality of groups of optoelectronic conversion modules that are electrically connected to the processor chip are configured to bear conversion between optical signals of a single wavelength and electrical signals, or the plurality of groups of optoelectronic conversion modules that are electrically connected to the processor chip are configured to bear conversion between optical signals of a plurality of wavelengths and electrical signals.

5. The silicon wafer-scale system according to claim 3, wherein each of the plurality of memory chips is electrically connected to the plurality of groups of optoelectronic conversion modules; and
the plurality of groups of optoelectronic conversion modules that are electrically connected to the memory chip are configured to bear conversion between optical signals of a single wavelength and electrical signals, or the plurality of groups of optoelectronic conversion modules that are electrically connected to the memory chip are configured to bear conversion between optical signals of a plurality of wavelengths and electrical signals.

6. The silicon wafer-scale system according to claim 3, further comprising: a first drive circuit in a one-to-one correspondence with the photoelectric modulator, and a second drive circuit in a one-to-one correspondence with the photodetector, wherein
the photoelectric modulator is electrically connected to a corresponding processor chip or memory chip through the first drive circuit; and
the photodetector is electrically connected to a corresponding processor chip or memory chip through the second drive circuit.

7. The silicon wafer-scale system according to claim 6, wherein both the first drive circuit and the second drive circuit are integrated in the optical interconnect layer, the first drive circuit is electrically connected to the photoelectric modulator through a metal interconnect line, and the second drive circuit is electrically connected to the photodetector through a metal interconnect line.

8. The silicon wafer-scale system according to claim 6, wherein both the first drive circuit and the second drive circuit that are electrically connected to the processor chip are integrated in the processor layer, and both the first drive circuit and the second drive circuit are electrically connected to the processor chip through metal interconnect lines; and/or
both the first drive circuit and the second drive circuit that are electrically connected to the memory chip are integrated in the memory layer, and both the first drive circuit and the second drive circuit are electrically connected to the memory chip through metal interconnect lines.

9. The silicon wafer-scale system according to any one of claims 1 to 8, wherein the optical interconnect layer comprises a plurality of optical waveguides, the plurality of optical waveguides comprise a first optical waveguide extending in a first direction and a second optical waveguide extending in a second direction, and the first direction and the second direction are crossed; and
the optical interconnect layer further comprises: an optical switch disposed at a cross location of the first optical waveguide and the second optical waveguide, and the optical switch is configured to control transmission of an optical signal to be switched between the first optical waveguide and the second optical waveguide.

10. The silicon wafer-scale system according to any one of claims 1 to 9, wherein the optical interconnect layer further comprises at least one group of input/output modules, each group of input/output modules in the at least one group of input/output modules comprise an optical coupling module and an optical fiber, and the optical fiber is coupled to the optical waveguide through the optical coupling module.

11. The silicon wafer-scale system according to any one of claims 1 to 10, wherein the plurality of processor chips comprise a first processor chip and a second processor chip that are adjacent to each other, and the first processor chip and the second processor chip are electrically connected through a metal interconnect line.

12. The silicon wafer-scale system according to any one of claims 1 to 11, wherein the plurality of memory chips comprise a first memory chip and a second memory chip that are adjacent to each other, and the first memory chip and the second memory chip are electrically connected through a metal interconnect line.

13. The silicon wafer-scale system according to any one of claims 1 to 12, wherein the processor layer and the optical interconnect layer are electrically connected in a hybrid bonding manner, and the optical interconnect layer and the memory layer are electrically connected in a hybrid bonding manner.

14. The silicon wafer-scale system according to any one of claims 1 to 13, further comprising: a heat dissipation module located on an upper side and/or a lower side of the silicon wafer-scale system.

15. The silicon wafer-scale system according to any one of claims 1 to 14, further comprising: a power supply module located on the upper side and/or the lower side of the silicon wafer-scale system.

16. An electronic device, comprising a circuit board and the silicon wafer-scale system according to any one of claims 1 to 15, wherein the silicon wafer-scale system is electrically connected to the circuit board.

17. A repair method of the silicon wafer-scale system according to any one of claims 1 to 15, comprising:
separately testing a processor layer, a memory layer, and an optical interconnect layer, to determine a damaged processor chip, a damaged memory chip, and a damaged optoelectronic conversion module; and
shielding the damaged processor chip, the damaged memory chip, and the damaged optoelectronic conversion module during compiling of a program.
